Europäisches Patentamt

European Patent Office

Office européen des brevets

(11) Publication number: **0 023 818**
**B1**

(12) # EUROPEAN PATENT SPECIFICATION

(45) Date of publication of patent specification: **16.04.86**

(51) Int. Cl.⁴: **H 01 L 23/52**

(21) Application number: **80302606.1**

(22) Date of filing: **30.07.80**

(54) **Semiconductor integrated circuit device including a master slice and method of making the same.**

(30) Priority: **31.07.79 JP 97623/79**

(43) Date of publication of application:
**11.02.81 Bulletin 81/06**

(45) Publication of the grant of the patent:
**16.04.86 Bulletin 86/16**

(84) Designated Contracting States:
**DE FR GB NL**

(56) References cited:
FR-A-2 374 817
JP-A-54 093 375
US-A-3 936 812

SIEMENS RESEARCH AND DEVELOPMENT
REPORTS, vol. 5, no. 6, 1976, pages 344-349,
Berlin (DE); E. GONAUSER et al.: "A master
slice design concept based on master cells in
ESFI-SOS-CMOS technology"

(73) Proprietor: **FUJITSU LIMITED**
**1015, Kamikodanaka Nakahara-ku**
**Kawasaki-shi Kanagawa 211 (JP)**

(72) Inventor: **Sugiura, Yoshihide**
**27-3-508 Nishigahara 1-chome, Kita-ku**
**Tokyo 114 (JP)**
Inventor: **Ichikawa, Hiroaki**
**13-18 Wakakusadai Midori-ku**
**Yokohama-shi Kanagawa 227 (JP)**
Inventor: **Matsumura, Nobutake**
**2-6-2-404 Kodai Takatsu-ku**
**Kawasaki-shi Kanagawa 213 (JP)**
Inventor: **Sasaki, Nobuo**
**1-14-240 Kawara-cho Saiwai-Ku**
**Kawasaki-shi Kanagawa 210 (JP)**

(74) Representative: **Rackham, Stephen Neil et al**
**GILL JENNINGS & EVERY 53-64 Chancery Lane**
**London WC2A 1HN (GB)**

Courier Press, Leamington Spa, England.

## Description

The present invention relates to a semiconductor integrated circuit device. More particularly, the present invention relates to an LSI (Large Scale Integration) semiconductor integrated circuit device including a master slice on which a great number of CMOS gate elements are arranged.

With an increase in the complexity of integrated circuits, the tendency to produce a great variety of products each in small quantities has become pronounced in the field of logic LSI circuit devices. Two ways of meeting this requirement are the gate array method and the master slice method. According to the master slice method, a large number of transistors are initially formed on a wafer so that a master slice is formed containing a large number of independent transistors. Then, a wiring mask is formed to interconnect the transistors in the master slice to form the required circuit. Therefore, mass production of the master slices is possible, and this reduces the period of development of LSI devices circuit and reduces its manufacturing cost. Furthermore, when the transistors in the master slice are arranged regularly the design can be effectively performed using an electronic computer. That is, CAD (computer aided design) is possible. Therefore, a saving in labour can be attained which not only shortens the development period but also prevents errors.

In our earlier JP—A 54-93375 we have already proposed a master slice comprising CMOS elements arranged regularly in both the longitudinal and the transverse directions on a semiconductor substrate. This master slice has advantages because the degree of freedom available for its wiring is remarkably high, various logic gates such as NAND and NOR gates and flip-flops can be prepared from this master slice, and the degree of integration is also high.

An article in "Siemens Research and Development Reports" volume 5, No. 6, 1976, on pages 344—349 by E. Gonauser et al., and entitled "A master slice design concept based on master cells in ESFI-SOS-CMOS technology", discloses a semiconductor integrated circuit device comprising a master slice formed by the epitaxial silicon film on insulator technique and containing a number of basic semiconductor elements arranged in a regular array of columns and rows, and customising wiring conductors interconnecting the basic semiconductor elements to customise the master slice to provide an integrated circuit chip capable of performing a required logic operation.

A diffusion layer, a polycrystalline silicon film and a film of a metal such as aluminium can all be used to provide customising wiring conductors in a MOS LSI circuit device. Where a diffusion layer is used as wiring, a high impurity concentration layer is formed on a semiconductor substrate by diffusion. This layer has a low resistivity. Therefore, the diffusion layer is only applied over limited regions to provide the interconnections required. Furthermore, since there is a large capacity between the substrate and the diffusion layer, this type of wiring is not suitable for a long distance signal line. A polycrystalline silicon film is often used as the gate electrode of a field effect transistor and, a polycrystalline silicon film is suitable as wiring when it is desired to connect the gate electrode or at a part of the gate electrode of such a transistor because simultaneous formation of the electrode gate and the wiring layer is possible. Metal film wiring, especially using an aluminium film, is most frequently adopted because of its low resistivity. However, aluminium readily reacts with a silicon dioxide layer which is often used as an insulating base layer, especially when it is thin. Sometimes this leads to insufficient insulation and leads to the resistivity of the aluminium layer being increased. Moreover, a high temperature heat treatment of a device including an aluminium wiring layer is not possible because the film tends to break down while in a molten state at the high temperature.

Multi-layer wiring is used, in which wiring layers are arranged to intersect one another and even if they do not contact each other, as in a case of grid wiring, longitudinal lines and transverse lines are independently laid out in a first layer and a second layer, respectively. In this case, a method is adopted in which polycrystalline silicon is used for a first base layer and aluminium is used for a second base layer located above the first base layer. The resistivity of the polycrystalline silicon is higher than that of aluminium. Incidentally, in a case of multi-layer wiring, the number of layers is usually 2 or 3, and if the number of layers is increased, the surface on which the layers are deposited becomes irregular and the convexities and concavities on the base are sufficiently large to cause breakage of the lines.

According to this invention such a master slice of a semiconductor integrated circuit device also includes wiring conductors arranged in between the columns or rows of the basic semiconductor elements, at least some of the wiring conductors being cut and used to provide at least part of the customising wiring conductors.

The wiring conductors formed as part of the master slice may be formed simultaneously with the formation of a diffusion layer or a polycrystalline silicon layer used in the basic semiconductor elements. In this way the diffusion layer or polycrystalline silicon layer is formed as a first layer of the wiring in the substrate, so that the number of layers is increased by one without changing the evenness of the base.

Particular examples of integrated circuit devices in accordance with this invention will now be described with reference to the accompanying drawings; in which:—

Figure 1 is a circuit diagram of a basic semiconductor element that is used in a device in accordance with the present invention;

Figure 2 is a plan of the basic semiconductor element illustrated in Figure 1;

Figure 3 is a plan of part of a master slice used in the device in accordance with the present invention;

Figure 4 is a plan to an enlarged scale of parts of the master slice shown in Figure 3;

Figure 5 is a plan of the basic semiconductor elements of the device in accordance with the present invention in an embodiment where the device is used to form a 2-input NAND gate and the symbol "x" shows the position of a contact hole;

Figures 6A and 6B are circuit diagrams illustrating the equivalent circuits of the device shown in Figure 5;

Figures 7A, 7B, 7C and 7D are diagrams illustrating steps in forming a wiring diffusion layer pattern on the device shown in Figure 5;

Figures 8A, 8B, 8C and 8D are diagrams illustrating steps in forming a wiring pattern in an embodiment of the device in which polycrystalline silicon layers are used for the wiring pattern;

Figures 9A and 9B are circuit diagrams showing the circuit of a 2-input NAND gate and its symbol and Figure 9C is a plan of the wiring of the device; and,

Figures 10A and 10B are circuit diagrams illustrating a symbol and a circuit of a flip-flop, and Figure 10C is a plan of the wiring of the device.

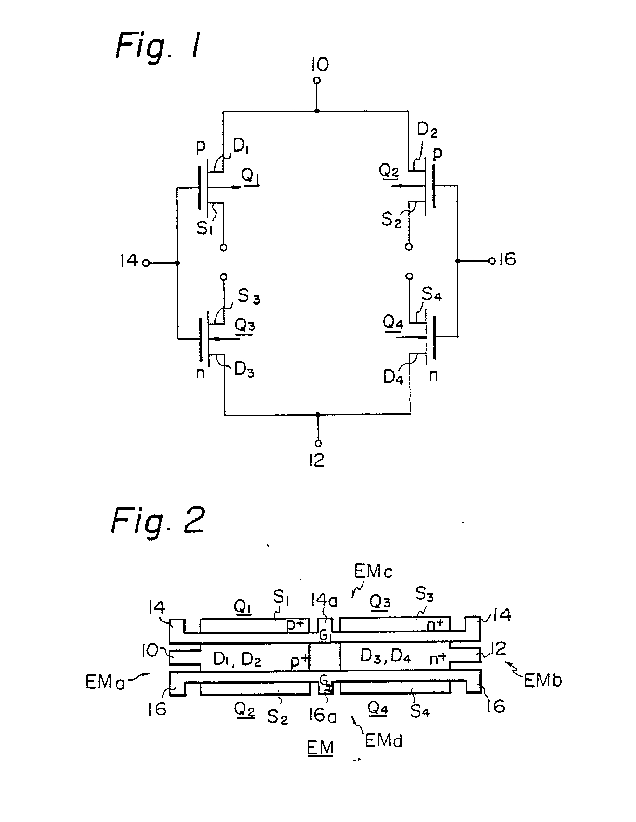

Referring to Figure 1 showing a CMOS element used as a basic semiconductor element in the device of the present invention, $Q_1$ and $Q_2$ each represent a p-channel MOS field effect transistor, and $Q_3$ and $Q_4$ each represent an n-channel MOS field effect transistor. As illustrated in Fig. 2, drain regions $D_1$ and $D_2$ of the transistors $Q_1$ and $Q_2$ have one $p^+$-diffusion layer in common, and a terminal 10 is connected to this diffusion layer. Also the drain regions $D_3$ and $D_4$ of the transistors $Q_3$ and $Q_4$ have one $n^+$-diffusion layer in common as illustrated in Fig. 2, and a terminal 12 is connected to this diffusion layer. $S_1$ and $S_2$ represent $p^+$-source regions of the transistors $Q_1$ and $Q_2$, respectively, and $S_3$ and $S_4$ represent $n^+$-source regions of the transistors $Q_3$ and $Q_4$, respectively. Gates of the transistors $Q_1$ and $Q_3$ and of the transistors $Q_2$ and $Q_4$ are constructed by common gate electrodes $G_1$ and $G_2$, respectively, and terminals 14 and 16 are connected to these common gate electrodes $G_1$ and $G_2$, respectively. Channels are formed in semiconductor layers (n-type layer for $Q_1$ and $Q_2$ and p-type for $Q_3$ and $Q_4$) below these gate electrodes $G_1$ and $G_2$. Although the source regions $S_1$, $S_2$, $S_3$ and $S_4$ of the respective transistors are not connected in the drawings, if the source regions $S_1$ and $S_2$ are connected to the source regions $S_3$ and $S_4$, respectively and the contact points are used as output terminals, two known CMOS inverters connected in parallel are constructed.

A pattern of a wiring layer will now be described. If the above-mentioned diffusion layer is utilized for a wiring pattern, since said diffusion layer is formed within a semiconductor substrate, it is a so-called zero layer. Accordingly, if said diffusion layer is utilized as wiring pattern, a first layer becomes a second layer and a second layer becomes a third layer. In other words, the number of layers is increased by 1 without changing the levelness of the base, and this arrangement is advantageous in this point. However, if an ordinary semiconductor substrate such as mentioned above is used, since stray capacity is increased, utilization of this arrangement as a long distance signal line is impossible.

However, the circumstances are quite different in a case of a semiconductor device having a silicon-on-sapphire (SOS) structure. More specifically, a diffusion layer formed in silicon epitaxial growth layer formed on a sapphire substrate has a much smaller stray capacity than that of a diffusion layer formed on a silicon bulk substrate, and the device can be used as a signal line. Furthermore, the diffusion layer of the SOS element is characterized in that since an etching solution for a silicon epitaxial layer is different from an etching solution for a sapphire substrate, the diffusion layer can easily be cut. When the diffusion layer is used as the wiring material of a master slice, since a wiring pattern is not decided at a time of formation of the diffusion layer (it is not decided what circuit structure will be given to LSI) and since formation of the diffusion layer is possible only at a step of forming a transistor or the like on a substrate, while formation of the diffusion layer is impossible at a subsequent step, the property of being easily cut is a very important characteristic for the wiring material.

Therefore, an embodiment in which a semiconductor substrate having an SOS structure is used will now be described in detail.

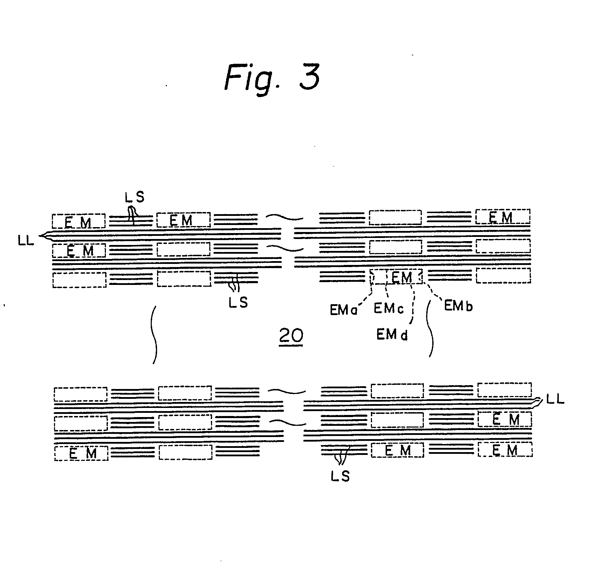

Fig. 3 illustrates a master slice according to this embodiment, in which basic semiconductor elements EM are arranged at predetermined intervals regularly in lines and rows on a sapphire substrate (not labelled in Fig. 3) and diffusion wiring patterns LS and LL are formed among the elements EM. As illustrated in Fig. 2, gate and drain terminals 14, 16, 10 and 12 of the elements EM are gathered on both the ends in a lateral direction and only gate intermediate terminals 14a and 16a are formed on both the ends in the longitudinal direction. In the embodiment illustrated in Fig. 3, terminal gathering ends EMa and EMb of the basic semiconductor elements EM are arranged in lines and terminal non-gathering edges EMc and EMd of the basic semiconductor elements EM are arranged in rows. Several (3 in the present embodiment) short diffusion wiring patterns LS are formed in a region between the confronting terminal gathering edges EMa and EMb of adjacent elements EM, and the same number of long diffusion wiring patterns LL are formed in a region between the confronting terminal non-gathering ends EMc and EMd of adjacent elements EM so that they extend along the entire length of the elements EM. The length of the diffusion wiring pattern LS is such that 10 and odds of aluminum wiring lines may be laid out on said pattern while intersecting said pattern. The length of the basic semiconductor element EM in a line direction is such that aluminum wiring lines for sources and drains and aluminum wiring lines necessary for connecting these elements EM to form a desired logic circuit can be formed.

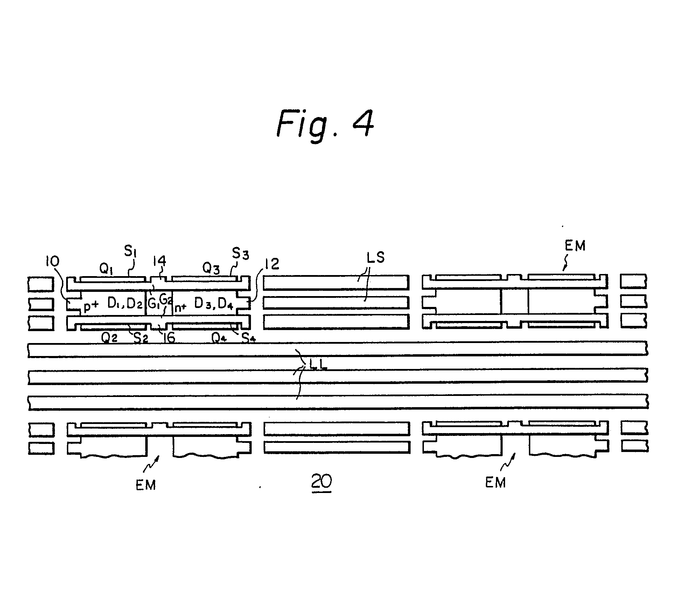

Fig. 4 is an enlarged view illustrating parts of the master slice illustrated in Fig. 3. Both the wiring patterns LS and LL extend in parallel to each other in the line direction. It is preferred that the number of the patterns LS between two elements be 2 through 5 and the number of the patterns LL between two elements be 2 or 3. The wiring pitch of the patterns LS is made to be larger than the wiring pitch of the patterns LL. The short diffusion layers LS are mainly used for connecting input and output terminals of the elements to input and output lines, and this connection can be accomplished by bridging an input or output terminal of an element to an end of the wiring pattern LS with a short aluminum layer. The long diffusion layers LL are used for connecting elements separated from each other or as power source lines. Of course, lines and rows indicating the directions of formation of these patterns may be interchanged.

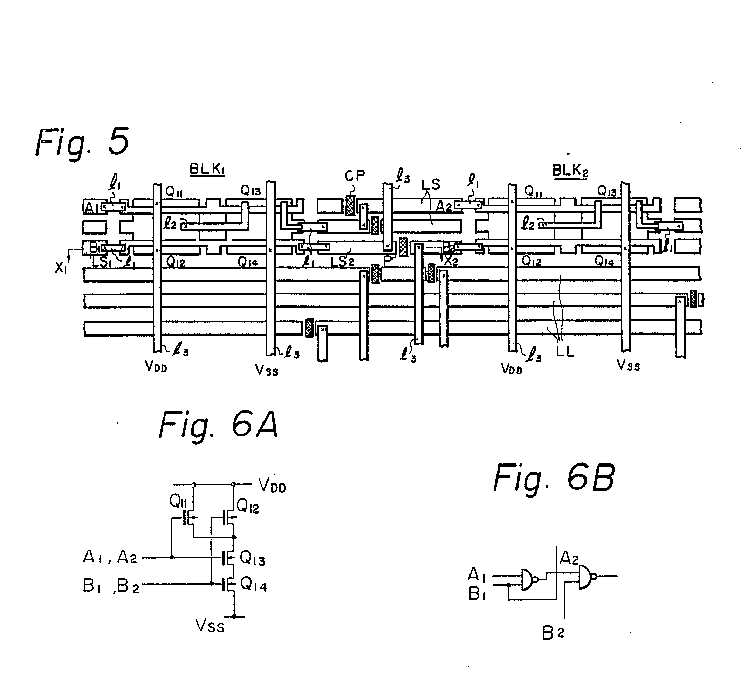

By using the above-mentioned master slice, there can be formed various logic gates of basic circuits such as AND, OR, NAND and NOR circuits and modified circuits such as 2-input type circuits and 3-input type circuits, and various flip-flops such as RS, D, T and J-K flipflops. By way of example, a NAND gate including the above master slice is illustrated in Fig. 5. Blocks $BLK_1$ and $BLK_2$ in Fig. 5 are 2-input NAND gates as illustrated in the circuit diagram of Fig. 6A, and the entire circuit structure is illustrated in Fig. 6B. Input signals $A_1$, $A_2$, $B_1$ and $B_2$, power sources $V_{DD}$ and $V_{SS}$ and transistors $Q_{11}$, $Q_{12}$, $Q_{13}$ and $Q_{14}$ are arranged and connected as illustrated in Fig. 5. In Fig. 5, $l_1$ represents a bridge for connecting the end of the short diffusion wiring pattern LS to the input or output end of the element, and $l_2$ represents an L-shaped wiring for connecting a source or drain of one CMOS inverter to a drain or source another CMOS inverter. Furthermore, $l_3$ represents a wiring extending in a row direction acting as a line connected to the power source $V_{DD}$ or $V_{SS}$. Each of $l_1$, $l_2$ and $l_3$ is formed of aluminum. CP represents a pattern cut for cutting the wiring pattern LS or LL into 2, 3 or more portions so that the respective portions act as independent signal lines. Marks X indicate contact holes on either the diffusion layer and aluminum wiring.

As can be understood from Fig. 5, the diffusion wiring patterns LS and LL are cut and then used in the cut state. Accordingly, one diffusion pattern can be used as a plurality of signal lines, and wiring channels can be utilized more effectively than in a diffusion line-buried type master slice where the diffusion layer is not cut, and therefore, an effect of diminishing the chip size can be attained. The diffusion wiring pattern is formed by ion implantation of an n-type impurity such as arsenic (As) into a silicon layer on a sapphire substrate 20. Insulation of the wiring patterns LS and LL from the surrounding portions is accomplished by (a) a method in which they are separated from surrounding portions by etching, (b) a method in which surrounding portions are formed of an insulating material such as silicon dioxide or (c) a method in which pn junctions are formed. When an $n^+$-type diffusion layer is used as the wiring pattern, the value of the resistance is several times lower than in a case of a $p^+$-type diffusion layer.

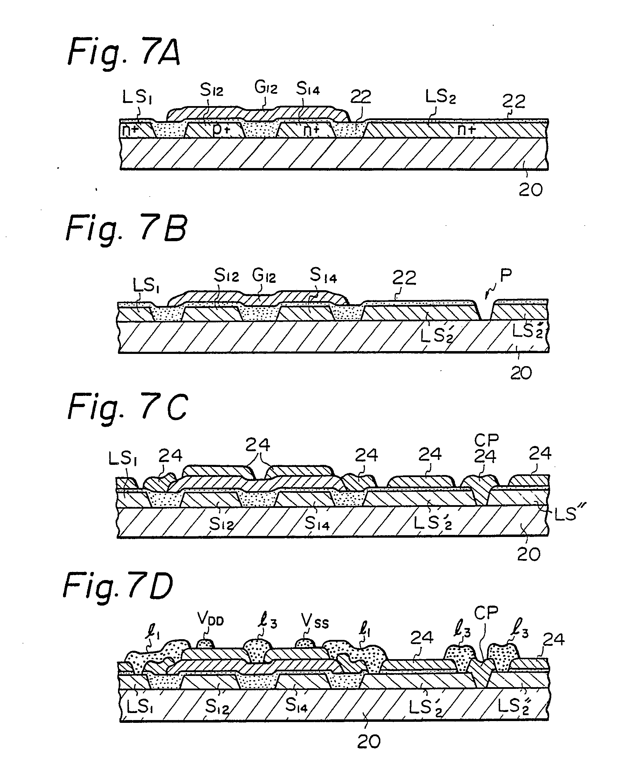

A step of cutting diffusion wiring patterns will now be described with reference to Figs. 7A, 7B, 7C and 7D. Fig. 7A is a view illustrating a section taken along line $X_1$—$X_2$ in Fig. 5, which illustrates the state of the master slice before cutting. In Fig. 7A, there are illustrated a diffusion wiring pattern $LS_1$, a source region $S_{12}$ of a transistor $Q_{12}$ (shown in Fig. 6A), a source region $S_{14}$ of a transistor $Q_{14}$ (shown in Fig. 6A), a diffusion wiring pattern $LS_2$ and a grate electrode $G_{12}$. Reference numeral 20 represents a sapphire substrate and reference numeral 22 represents a silicon dioxide layer insulating the surface and respective regions. As illustrated in Fig. 7B, cutting of the diffusion wiring pattern $LS_2$ at a point P is accomplished by etching on the surface of the $SiO_2$ layer 22, further etching the diffusion wiring pattern $LS_2$ below the $SiO_2$ layer 22 and dividing the pattern $LS_2$ into independent $LS'_2$ and $LS''_2$ patterns. At this stage, the pattern $LS_2$ is in an as-obtained state after ion implantation of an n-type impurity thereinto in the form of a band into a silicon epitaxial growth layer. Accordingly, since etching is carried out before annealing, there are present many lattice defects and hence, the etching speed is very high, and therefore, the time required for etching can be shortened. After this cutting step, annealing is effected and the pattern $LS_2$ is covered with a PSG film 24 (Fig. 7C). Then, etching is carried out and a window is opened in a portion where the pattern $LS_2$ becomes contact with an aluminum film to be capped thereon. This state is illustrated in Fig. 7C. Then, by using a similar mask, aluminum is metalized to form wirings $l_1$, $l_3$, $V_{DD}$ and $V_{SS}$ as illustrated in Fig. 7D. Aluminum is used as wiring lines in the wiring channel in longitudinal direction (portion LL), lines connecting take-out portions of terminals of the respective elements, wiring lines on the elements EM (especially, unused elements) and power source lines. As will be apparent from the sectional views of Figs. 7A through 7D, in the SOS device, a p- or n-well is not necessary even for a CMOS, and source and drain regions of a p-channel and n-channel elements can be directly formed by doping of p- and n-type impurities while they are insulated by $SiO_2$ or the like. This feature is advantageous from the viewpoints of reduction of stray capacity and prevention of formation of pnpn hook elements.

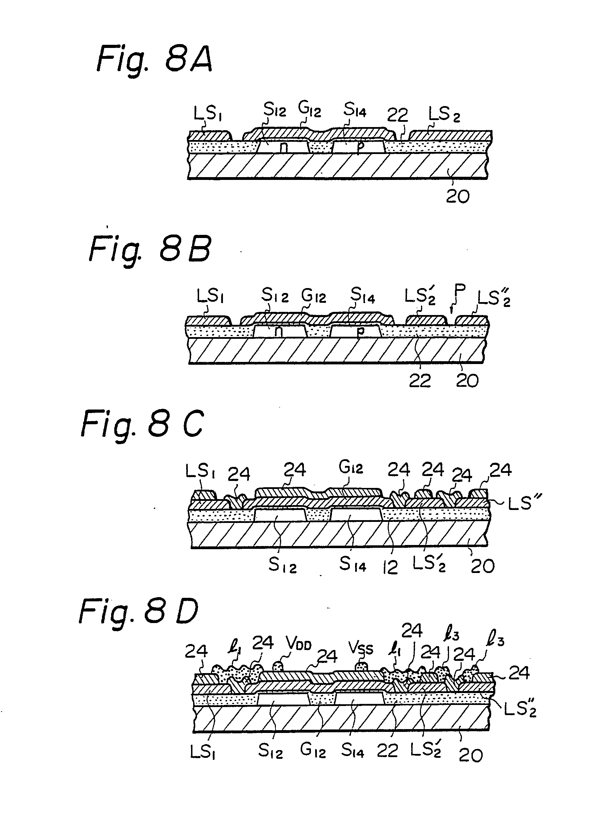

An embodiment where the diffusion layer which is formed on a sapphire substrate simultaneously with formation of the diffusion layer of a basic semiconductor element, that is a CMOS element, is used as a wiring pattern has been described hereinbefore. Of course, in the present invention, a polycrystalline silicon layer which is formed simultaneously with formation of a gate electrode of a CMOS element can be used as a wiring pattern. A cutting step in an embodiment where such a polycrystalline layer is used as the wiring pattern is shown in Figs. 8A, 8B, 8C and 8D. In Figs. 8A through 8D, the same reference numerals and symbols as used in Figs. 7A through 7D represent parts and elements corresponding to those in Figs. 7A through 7D. The main difference of the embodiment shown in Figs. 8A through 8D from the embodiment shown in Figs. 7A through 7D resides int hat wiring patterns $LS_1$ and $LS_2$ are formed simultaneously with formation of a polycrystalline silicon layer to be used as the gate electrode $G_{12}$. Cutting of the wiring patterns $LS_1$ and $LS_2$ and connection to lines $I_1$, $I_3$, $V_{DD}$ and $V_{SS}$ can be carried out in the same manner as in a case of the diffusion layer patterns described hereinbefore with reference to Figs. 7A through 7D. Therefore, detailed description is omitted here.

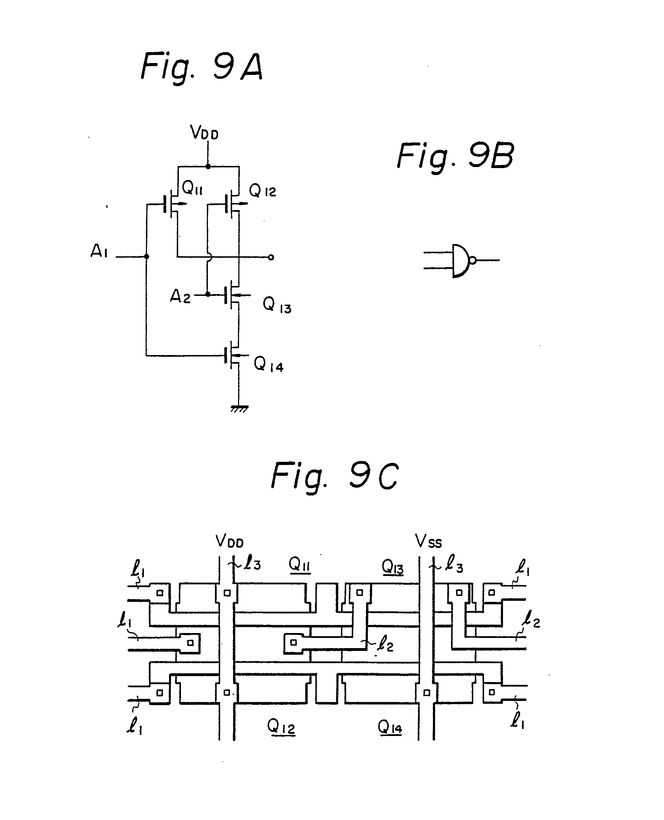

A circuit, symbol and wiring pattern of a 2-input NAND gate are collectively shown in Figs. 9A, 9B and 9C. The reference numerals and symbols represent parts and elements corresponding to those in Figs. 5 and 6.

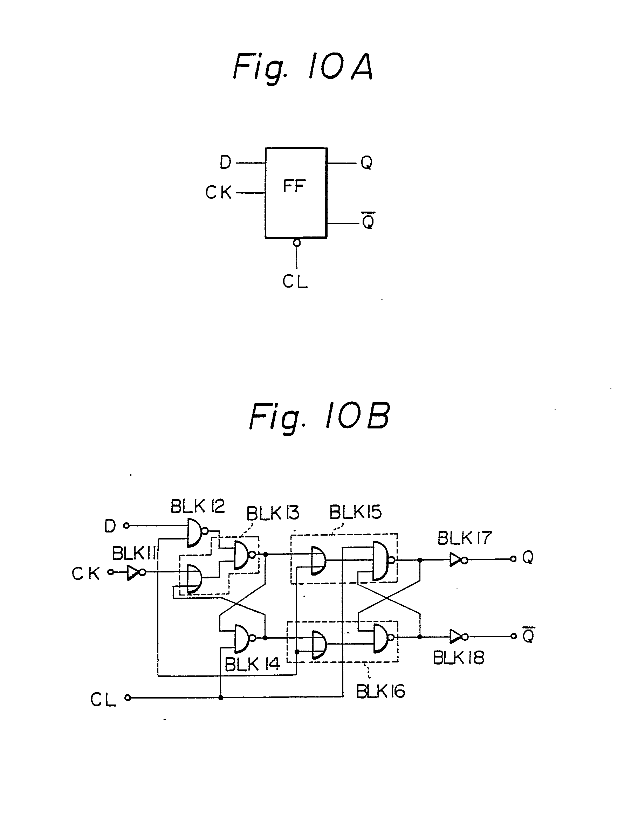

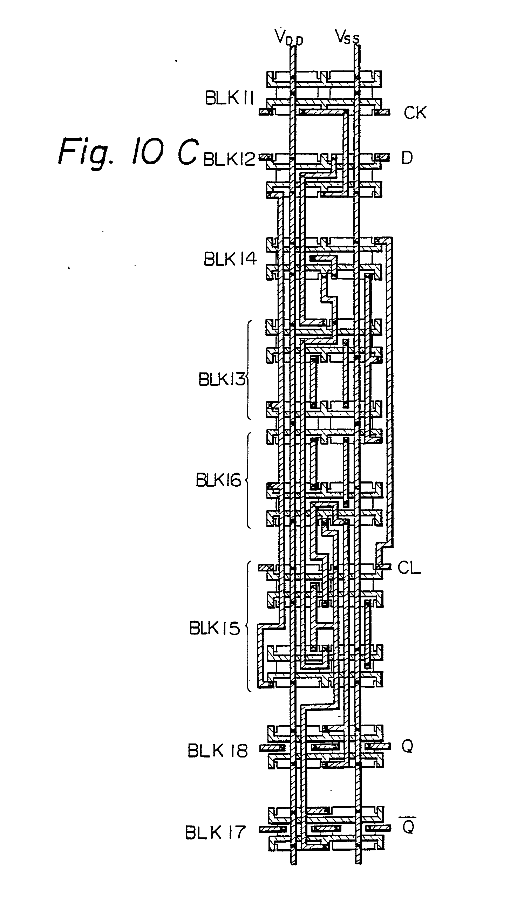

A symbol mark, circuit and wiring pattern of the flip-flop are shown in Figs. 10A, 10B and 10C for reference. Relations among blocks $BLK_{11}$ through $BLK_{18}$ forming flip-flop and plane patterns thereof are apparent from Figs. 10B and 10C. In Fig. 10C, only aluminum lines are indicated by thick lines, and connecting lines in each block are not shown.

When a basic semiconductor element of the present invention is used, any number of kinds of logic functional cells (multi-input NAND and NOR gates, flip-flops and the like) can be prepared by appropriately adding aluminum wiring lines and cutting diffusion wiring patterns. Wiring patterns for respective logic functions are stored in a file, and three mask data, that is, data for mask for cutting diffusion wiring patterns, a contact hole pattern and an aluminum wiring mask, are automatically designed and prepared based on the data stored in such a file by an electronic computer. Masks are formed based on said data, and by using the masks, thus formed, a line connection is performed in the basic semiconductor element according to the present invention, whereby a LSI of a desired logic can be obtained. The following advantages can be attained according to the present invention.

(1) Since the capacity of a diffusion wiring pattern on a sapphire substrate is smaller than the capacity of a diffusion wiring pattern in a silicon substrate, a high speed operation becomes possible, and a LSI of one metal layer can be realized by using this diffusion wiring pattern positively as the wiring line.

(2) Since a LSI of a desired logic can be formed only by cutting diffusion patterns and forming contact holes and wiring metal patterns on a master slice, the number of steps necessary for forming a LSI can be reduced as compared with the number of steps required in a master slice including two metal layers.

(3) Since an optional number of signal lines can be formed only by cutting the diffusion wiring pattern, it becomes possible to utilize wiring channels effectively.

(4) Since the substrate is formed of sapphire, cutting of diffusion wiring patterns can be accomplished very easily. Not only an etching method but also a method using laser or electron beams can be used for cutting diffusion pattern layers. In each of these cases, since the surface silicon layer is different from the sapphire substrate in cutting rate, cutting is stopped at the surface of the sapphire substrate, and maintenance and control of the cutting step can be facilitated.

(5) Since a master slice used in the present invention is a CMOS master slice having a SOS structure, p-wells and channel cuts necessary for an ordinary bulk CMOS master slice need not be formed and a highly integrated MIS device having a diminished chip size can be advantageously obtained.

**Claims**

1. A semiconductor integrated circuit device comprising a master slice formed by the epitaxial silicon film on insulator technique and containing a number of basic semiconductor elements (EM) arranged in a regular array of columns and rows, and customising wiring conductors interconnecting the basic semiconductor elements (EM) to customise the master slice to provide an integrated circuit chip capable of performing a required logic operation, characterised in that the master slice includes wiring conductors (LL, LS) arranged in between the columns or rows of the basic semiconductor elements, at least some of the wiring conductors (LL, LS) being cut and used to provide at least part of the customising wiring conductors.

2. A semiconductor integrated circuit device according to claim 1, wherein the wiring conductors comprise a plurality of first wiring conductors (LS) formed between adjacent basic semiconductor elements (EM) in each column or row, and a plurality of second wiring conductors (LL) formed between the adjacent columns or rows, respectively, of the basic semiconductor elements (EM) and extending in the direction of the columns or rows, respectively.

3. A semiconductor integrated circuit device according to claim 1 or claim 2, wherein the basic semiconductor elements (EM) are each formed by a pair of CMOS elements which comprise a first diffusion layer including three $n^+$-type diffusion layers ($S_3$; $D_3$, $D_4$; $S_4$) acting as source or drain regions and two p-type regions, each p-type region being sandwiched between two of the $n^+$-type diffusion layers ($S_3$ and $D_3$ or $S_4$ and $D_4$), a second diffusion layer including three $p^+$-type diffusion layers ($S_1$; $D_1$, $D_2$; $S_2$) acting as source or drain regions and two n-type regions, each n-type region being sandwiched between two of the p⁺-type diffusion layers ($S_1$ and $D_1$ or $S_2$ and $D_2$), and first and second polycrystalline silicon layers ($G_1$, $G_2$) extending parallel to each other over the first and second diffusion layers, the polycrystalline silicon layers ($G_1$, $G_2$) forming gate electrodes.

4. A semiconductor integrated circuit device according to claim 3, wherein the wiring conductors (LL and LS) are formed by diffusion layers formed simultaneously with the first and second diffusion layers.

5. A semiconductor integrated circuit device according to claim 3, wherein the wiring conductors (LL and LS) are formed by polycrystalline silicon layers formed simultaneously with the first and second polycrystalline silicon layers ($G_1$, $G_2$).

6. A master slice formed by the epitaxial silicon film on insulator technique and containing a number of basic semiconductor elements (EM) for forming a semiconductor integrated circuit device, characterised in that it also includes wiring conductors (LL, LS) arranged in between the columns or rows of the basic semiconductor elements (EM), the wiring conductors (LL, LS) being used in a subsequent customising step to provide at least some of the customising wiring.

7. A master slice according to claim 6, in which the wiring conductors comprise a plurality of first wiring conductors (LS) formed between adjacent basic semiconductor elements (EM) in each column or row, and a plurality of second wiring conductors (LL) formed between the adjacent columns or rows, respectively, of the basic semiconductor elements (EM) and extending in the direction of the columns or rows, respectively.

8. A master slice according to claim 6 or 7, in which the basic semiconductor elements (EM) and the wiring conductors (LL, LS) are all electrically insulated from one another.

9. A method of making a semiconductor integrated circuit device comprising the steps of:

a) providing a master slice formed by the epitaxial silicon film on insulator technique and containing a number of basic semiconductor elements (EM) and wiring conductors (LL, LS) arranged in between the columns or rows of the basic semiconductor elements (EM); and,

b) cutting at least some of the wiring conductors (LL, LS) and establishing contact between at least some of the wiring conductors (LL, LS) and at least some of the basic semiconductor elements (EM) to provide the customising wiring conductors to interconnect the basic semiconductor elements (EM) to form required logic circuit elements.

**Revendications**

1. Dispositif à semiconducteur à circuit intégré comprenant une matrice mère formée par la technique de croissance épitaxiale d'une film de silicium sur un isolant et contenant un certain nombre d'éléments à semiconducteur de base (EM) disposés dans une matrice régulière de colonnes et de rangées, et des conducteurs de câblage d'adaptation particulière interconnectant les éléments à semiconducteur de base (EM) pour adapter en vue d'une utilisation particulière la matrice mère pour obtenir une pastille de circuit intégré permettant d'exécuter une opération logique voulue, caractérisé en ce que la matrice mère comprend des conducteurs de câblage (LL, LS) placés dedans entre les colonnes ou entre les rangées des éléments à semiconducteur de base, au moins certains des conducteurs de câblage (LL, LS) étant coupés et utilisés pour fournir au moins une partie des conducteurs de câblage d'adaptation particulière.

2. Dispositif à semiconducteur à circuit intégré selon la revendication 1, caractérisé en ce que les conducteurs de câblage comprennent un ensemble de premiers conducteurs de câblage (LS) formés entre des éléments à semiconducteur de base (EM) voisins dans chaque colonne ou dans chaque rangée, et un ensemble de seconds conducteurs de câblage (LL) formés entre les colonnes ou les rangées voisines, respectivement, des éléments à semiconducteur de base (EM) et s'étendant respectivement dans la direction des colonnes ou des rangées.

3. Dispositif à semiconducteur à circuit intégré selon l'une quelconque des revendications 1 et 2, caractérisé en ce que les éléments à semiconducteur de base (EM) sont constitués chacun d'une paire d'éléments à métal-oxyde-semiconducteur à symétrie complémentaire (CMOS) qui comprennent une première couche de diffusion incluant trois couches de diffusion de type n⁺ ($S_3$; $D_3$, $D_4$; $S_4$) servant de régions de source ou de drain et comme deux régions de type p, chaque région de type p étant placés en sandwich entre deux des couches de diffusion de type n⁺ ($S_3$ et $D_3$ ou $S_4$ et $D_4$), une deuxième couche de diffusion incluant trois couches de diffusion de type p⁺ ($S_1$; $D_1$, $D_2$; $S_2$) servant de régions de source ou de drain et comme deux régions de type n, chaque région de type n étant placés en sandwich entre deux des couches de diffusion de type p⁺ ($S_1$ et $D_1$ ou $S_2$ et $D_2$), et des première et deuxième couches de silicium polycristallin ($G_1$, $G_2$) s'étendant parallèlement entre elles par dessus les première et deuxième couches de diffusion, les couches de silicium polycristallin ($G_1$, $G_2$) constituant des électrodes de grille.

4. Dispositif à semiconducteur à circuit intégré selon la revendication 3, caractérisé en ce que les conducteurs de câblage (LL et LS) sont constitués par des couches de diffusion formées en même temps que les première et deuxième couches de diffusion.

5. Dispositif à semiconducteur à circuit intégré selon la revendication 3, caractérisé en ce que les conducteurs de câblage (LL et LS) sont constitués par des couches de silicium polycristallin formées en même temps que les première et deuxième couches de silicium polycristallin ($G_1$, $G_2$).

6. Matrice mère formée par la technique de croissance épitaxiale d'un film de silicium sur un isolant et contenant un certain nombre d'éléments à semiconducteur de base (EM) pour former un dispositif à semiconducteur à circuit intégré, caractérisée en ce qu'elle comprend en outre des conducteurs de câblage (LL, LS) disposés dedans entre les colonnes ou les rangées des éléments à semiconducteur de base (EM), les conducteurs de câblage (LL, LS) étant utilisés dans une opération d'adaptation ultérieure en vue d'une utilisation particulière pour fournir au moins certains des conducteurs de câblage d'adaptation particulière.

7. Matrice mère selon la revendication 6, caractérisée en ce que les conducteurs de câblage comprennent un ensemble de premiers conducteurs de câblage (LS) formés entre des éléments à semiconducteur de base voisins (EM) dans chaque colonne ou dans chaque rangée, et un ensemble de seconds conducteurs de câblage (LL) formés entre les colonnes ou les rangées voisines, respectivement, des éléments à semiconducteur de base (EM) et s'étendant respectivement dans la direction des colonnes ou des rangées.

8. Matrice mère selon l'une quelconque des revendications 6 et 7, caractérisée en ce que les éléments à semiconducteur de base (EM) et les conducteurs de câblage (LL, LS) sont tous isolés électriquement entre eux.

9. Procédé de fabrication d'un dispositif à semiconducteur à circuit intégré, caractérisé en ce qu'il consiste à:

a) prévoir une matrice mère formée par la technique de croissance épitaxiale d'un film de silicium sur un isolant et contenant un certain nombre d'éléments à semiconducteur de base (EM) et de conducteurs de câblage (LL, LS) disposés dedans entre les colonnes ou les rangées des éléments à semiconducteur de base (EM); et à

b) couper au moins certains des conducteurs de câblage (LL, LS) et à établir des contacts entre au moins certains des conducteurs de câblage (LL, LS) et au moins certains des éléments à semiconducteur de base (EM) pour fournir les conducteurs de câblage d'adaptation particulière pour interconnecter les éléments à semiconducteur de base (EM) afin de former les éléments de circuit logique voulus.

**Patentansprüche**

1. Integrierte Halbleiterschaltungsvorrichtung mit einer Mutterscheibe, die durch die Technik eines epitaktischen Siliziumfilms auf einem Isolator gebildet ist und eine Anzahl von Basishalbleiterelementen (EM) umfaßt, die in einer regelmäßigen Anordnung von Spalten und Reihen angeordnet sind, und mit Verdrahtungsleitern für die Kundenanpassung, welche die Basishalbleiterelemente (EM) miteinander verbinden, um die Mutterscheibe für den Kunden anzupassen, um ein integriertes Schaltungschip zu bilden, welches eine erforderliche logische Operation durchführen kann, dadurch gekennzeichnet, daß die Mutterscheibe Verdrahtungsleiter (LL, LS) umfaßt, die zwischen den Spalten oder Reihen der Basishalbleiterelemente angeordnet sind, wobei wenigstens einige der Verdrahtungsleiter (LL, LS) durchtrennt sind und dazu verwendet werden, wenigstens einen Teil der Anpassungs-Verdrahtungsleiter zu bilden.

2. Integrierte Halbleiterschaltungsvorrichtung nach Anspruch 1, bei welcher die Verdrahtungsleiter eine Vielzahl von ersten Verdrahtungsleitern (LS) umfassen, welche zwischen benachbarten Basishalbleiterelementen (EM) in jeder Spalte oder Reihe gebildet sind, und eine Vielzahl von zweiten Verdrahtungshalbleitern (LL), welche sich zwischen benachbarten Spalten bzw. Reihen von den Basishalbleiterelementen (EM) in Richtung der Spalten bzw. Reihen erstrecken.

3. Integrierte Halbleiterschaltungsvorrichtung nach Anspruch 1 oder 2, bei welcher die Basishalbleiterelemente (EM) jeweils durch ein paar von CMOS-Elementen gebildet werden, welche eine erste Diffusionsschicht umfassen, die drei $n^+$-Typ-Diffusionsschichten ($S_3$; $D_3$, $D_4$; $S_4$) einschließt, welche als Source- oder Drain-Bereiche dienen, und zwei p-Typ-Bereiche, wobei jeder p-Typ-Bereich zwischen zwei der $n^+$-Typ-Diffusionsschichten ($S_3$ und $D_3$ oder $S_4$ und $D_4$) schichtartig angeordnet ist, eine zweite Diffusionsschicht, die drei $p^+$-Typ-Diffusionsschichten ($S_1$; $D_1$, $D_2$; $S_2$) einschließt, die als Source- oder Drain-Bereiche arbeiten, und zwei n-Typ-Bereiche von denen jeder n-Typ-Bereich schichtartig zwischen zwei der $p^+$-Typ-Diffusionsschichten ($S_1$ und $D_1$ oder $S_2$ und $D_2$) angeordnet ist, und erste und zweite polykristalline Siliziumschichten ($G_1$, $G_2$) die sich parallel zueinander über die ersten und zweiten Diffusionsschichten erstrecken, wobei die polykristallinen Siliziumschichten ($G_1$, $G_2$) Gate-Elektroden bilden.

4. Integrierte Halbleiterschaltungsvorrichtung nach Anspruch 3, bei welcher die Verdrahtungsleiter (LL und LS) durch Diffusionsschichten gebildet sind, welche gleichzeitig mit den ersten und zweiten Diffusionsschichten gebildet werden.

5. Integrierte Halbleiterschaltungsvorrichtung nach Anspruch 3, bei welcher die Verdrahtungsleiter (LL und LS) durch polykristalline Siliziumschichten gebildet sind, welche gleichzeitig mit den ersten und zweiten polykristallinen Siliziumschichten ($G_1$, $G_2$) gebildet werden.

6. Mutterscheibe, die durch die Technik eines epitaktischen Siliziumfilms auf einem Isolator gebildet ist und eine Anzahl von Basishalbleiterelementen (EM) zur Bildung einer integrierten Halbleiterschaltungsvorrichtung umfaßt, dadurch gekennzeichnet, daß sie auch Verdrahtungsleiter (LL, LS) umfaßt, die zwischen den Spalten oder Reihen der Basishalbleiterelemente (EM) angeordnet sind, wobei die Verdrahtungsleiter (LL, LS) bei einem folgenden Kundenanpassungsschritt dazu verwendet werden, wenigstens einen Teil der Kundenanpassungsverdrahtung zu bilden.

7. Mutterscheibe nach Anspruch 6, bei welcher die Verdrahtungsleiter eine Vielzahl von ersten Verdrahtungsleitern (LS) umfassen, die zwischen benachbarten Basishalbleiterelementen (EM) in jeder Spalte oder Reihe gebildet sind, und eine Vielzahl von zweiten Verdrahtungsleitern (LL), die zwischen benachbarten Spalten bzw. Reihen der Basishalbleiterelemente (EM) gebildet sind und sich in Richtung der Spalten bzw. Reihen erstrecken.

8. Mutterscheibe nach Anspruch 6 oder 7, bei welcher die Basishalbleiterelemente (EM) und die Verdrahtungsleiter (LL, LS) alle elektrisch voneinander isoliert sind.

9. Verfahren zur Herstellung einer integrierten Halbleiterschaltungsvorrichtung mit den folgenden Schritten:

a) Bildung einer Mutterscheibe, die durch die Technik eines epitaktischen Siliziumfilms auf einem Isolator gebildet ist und eine Anzahl von Basishalbleiterelementen (EM) und Verdrahtungsleitern (LL, LS) enthalt, die zwischen den Spalten oder Reihen der Basishalbleiterelemente (EM) angeordnet sind; und,

b) Durchtrennen von wenigstens einigen der Verdrahtungsleiter (LL, LS) und Herstellung des Kontakts zwischen wenigstens einigen der Verdrahtungsleiter (LL, LS) und wenigstens einigen der Basishalbleiterelemente (EM), um die Kundenanpassungs-Verdrahtungsleiter zu bilden, um die Basishalbleiterelemente (EM) miteinander zu verbinden, um die geforderten logischen Schaltungselemente zu bilden.

## Fig. 1

## Fig. 2

# Fig. 3

## Fig. 4

# Fig. 5

BLK₁     CP   ℓ₃   LS   ℓ₁     BLK₂

ℓ₁   Q₁₁    Q₁₃       A₂       Q₁₁    Q₁₃

A₁    ℓ₂              ℓ₂

B₁                 B₂       ℓ₁

X₁   LS₁   ℓ₁   Q₁₂    Q₁₄    ℓ₁   LS₂     X₂     Q₁₂    Q₁₄

ℓ₃        ℓ₃            ℓ₃        ℓ₃    LL

V_DD          V_SS             V_DD          V_SS

# Fig. 6A

V_DD

Q₁₁    Q₁₂

A₁ , A₂ —    Q₁₃

B₁ , B₂ —    Q₁₄

V_SS

# Fig. 6B

A₁
B₁      A₂

B₂

## Fig. 7A

## Fig. 7B

## Fig. 7C

## Fig.7D

*Fig. 8A*

*Fig. 8B*

*Fig. 8C*

*Fig. 8D*

## Fig. 9A

## Fig. 9B

## Fig. 9C

7

## Fig. IO A

## Fig. IO B

# 0 023 818

*Fig. 10 C*